(19) Europäisches Patentamt
European Patent Office
Office européen des brevets

(11) **EP 1 499 016 B1**

(12) **EUROPÄISCHE PATENTSCHRIFT**

(45) Veröffentlichungstag und Bekanntmachung des Hinweises auf die Patenterteilung:
**13.05.2009 Patentblatt 2009/20**

(51) Int Cl.:
*H03G 3/30* *(2006.01)*

(21) Anmeldenummer: **03016251.5**

(22) Anmeldetag: **17.07.2003**

(54) **Schaltungsanordnung und Verfahren zur Erhöhung des Wirkungsgrades eines Leistungsverstärkers**

Circuit and process for enhancing the efficiency of a power amplifier

Circuit et procédé pour l'augmentation de la efficacité d'un amplificateur de puissance

(84) Benannte Vertragsstaaten:
**DE FR GB**

(43) Veröffentlichungstag der Anmeldung:
**19.01.2005 Patentblatt 2005/03**

(73) Patentinhaber: **Palm, Inc.**
**Sunnyvale, CA 94085-2801 (US)**

(72) Erfinder: **Langer, Andreas**
**85716 Unterschleissheim-Lohhof (DE)**

(74) Vertreter: **von Samson-Himmelstjerna, Friedrich et al**
**Samson & Partner**
**Patentanwälte**
**Widenmayerstrasse 5**
**80538 München (DE)**

(56) Entgegenhaltungen:
| | |
|---|---|
| **EP-A- 1 146 636** | **US-A- 5 101 173** |
| **US-A1- 2002 146 993** | **US-A1- 2003 030 490** |

**Beschreibung**

Die Erfindung betrifft im Allgemeinen eine Schaltungsanordnung und ein Verfahren zur Erhöhung des Wirkungsgrades eines Leistungsverstärkers, vorzugsweise eines UMTS-Leistungsverstärkers, in einem Telekommunikationsendgerät.

Die meisten Leistungsverstärker mit einer linearen Kennlinie arbeiten im A-Betrieb oder im schwachen AB-Betrieb. Beim A-Betrieb ist die von der Schaltung des Leistungsverstärkers aufgenommene Gesamtleistung, unabhängig von der Aussteuerung konstant. Beim AB-Betrieb werden nur Teile der Stromperiode verstärkt. Die A-Betriebsweise ist zwar optimal für die Linearität der Kennlinie des Leistungsverstärkers, hat jedoch den Nachteil, dass die Effektivität mit zunehmenden Back-off, das ist die Differenz zwischen der mittleren Ausgangsleistung und der Sättigungsleistung des Leistungsverstärkers, dramatisch abnimmt. Bei Leistungsverstärkern im "reinen" A-Betrieb bedeuten 3 dB (dB = Dezibel) weniger Ausgangsleistung eine Halbierung der Effektivität. Bei linearen Leistungsverstärken wird daher oftmals der DC-Arbeitspunkt in Abhängigkeit der mittleren Ausgangsleistung umgeschaltet. Durch das Umschalten des Arbeitspunktes wird der Ruhestrom des Leistungsverstärkers verringert. Bei Dual-Bias Control wird zusätzlich die Versorgungsspannung des Leistungsverstärkers reduziert. Dies hat zwar den Vorteil, dass bei größerem Back-off der Wirkungsgrad verbessert wird, kann aber zu einer verringerten Verstärkung des Leistungsverstärkers führen. Die Reduktion der Verstärkung kann durch eine Erhöhung der Eingangsleistung kompensiert werden, damit die Ausgangsleistung konstant bleibt. Durch das Umschalten des Arbeitspunktes des Leistungsverstärkers kommt es zusätzlich zu einem Phasensprung in der Trägerphase.

Die Kompensation des Phasensprungs infolge Änderung des Arbeitspunktes, ist jedoch aufwendiger und erfordert neue Ansätze. Bisher gab es diesbezüglich keine Anforderungen, so dass bisher keine Notwendigkeit bestand, auftretende Phasensprünge infolge einer Änderung des Arbeitspunktes des Leistungsverstärkers zu kompensieren. Hintergrund der vorliegenden Erfindung ist eine im März 2003 getroffene Entscheidung der Normierungsgremien, in der nach 25.101 Release 5 der 3GPP (3rd generation partnership project) UMTS (universal mobile telecommunications system) FDD (frequency division duplex) Spezifikation, Phasensprünge auf maximal 60° zu begrenzen sind.

US 2003/0030490 A1 offenbart die Merkmal des Oberbegriffs des unabhängigen Anspruchs 1.

US 2002/0146993 A1 offenbart eine Schaltungsanordnung mit eine Vorspannung- und Verstärkungssteuerung eines Leistungsverstärkers in Abhängigkeit von dessen Ausgangssignal.

US 5,101,173 offenbart Anordnung, bei der die Vorspannung für einen Leistungsverstärker mittels eines Controllers in Abhängigkeit des Ausgangssignals des Leistungsverstärkers.

Es ist daher Aufgabe der Erfindung, eine Schaltungsanordnung zur Erhöhung des Wirkungsgrades eines Leistungsverstärkers vorzustellen, welche es gleichzeitig ermöglicht Phasenunterschiede zwischen den eingespeisten und den ausgegebenen Signalen des Leistungsverstärkers zu kompensieren. Entsprechend ist es Aufgabe der Erfindung ein Verfahren zur Erhöhung des Wirkungsgrades eines Leistungsverstärkers vorzustellen, bei dem Phasenunterschiede zwischen den eingespeisten und den ausgegebenen Signalen des Leistungsverstärkers kompensiert werden können.

Diese Aufgaben der Erfindung werden gegenständlich durch eine Schaltungsanordnung und ein Verfahren mit den Merkmalen der unabhängigen Patentansprüche gelöst. Vorteilhafte Weiterbildungen der Erfindung sind Gegenstand untergeordneter Patentansprüche.

Der Erfinder hat erkannt, dass bei Leistungsverstärkern in Telekommunikationsendgeräten eine sogenannte AM-PM Konversion (AM-PM = Amplitudenmodulation-Phasenmodulation) zu beobachten ist, das heißt die Phase des Trägers ist abhängig von der momentanen Eingangsleistung des Leistungsverstärkers. Zusätzlich ist die AM-PM Konversion abhängig von der Biasspannung der Transistoren. Bei Bipolaren Transistoren ist die Biasspannung die Basis-Emitter-Spannung. Bei Feld Effekt Transistoren (FET's) ist die Biasspannung die Gate-Source-Spannung.

Ursache für beide Effekte sind nichtlineare Energiespeicher, zum Beispiel Sperrschichtkapazitäten, die parallel oder in Serie mit einem Widerstand, einer Kapazität beziehungsweise einer Induktivität geschaltet sind.

Am Beispiel einer nichtlinearen Kapazität C in Serie mit einem Widerstand R wird der Effekt kurz erläutert. Beide Bauelemente zusammen bilden einen Tiefpass, wenn das Ausgangssignal am Kondensator abgegriffen wird. Ändert sich nun der Wert der Kapazität des Kondensators C(U) in Abhängigkeit von der Spannung U, die über dem Kondensator abfällt, so ändert sich die Grenzfrequenz $f_{Grenz}$ des Tiefpasses in Abhängigkeit dieser Spannung, wobei für die Grenzfrequenz folgende Proportionalität gilt:

$$f_{Grenz} \sim 1/R \cdot C(U).$$

Durch die Änderung der Grenzfrequenz wird die Phase zwischen Eingangs- und Ausgangssignal gedreht.

Übertragen auf den Leistungsverstärker bedeutet dies, dass beim Umschalten der Biasspannung sich der Wert des Kondensators zum Beispiel der Sperrschichtkapazität ändert. Dies führt zu einem Sprung in der Trägerphase, der natürlich davon abhängig ist, wie stark sich die Biasspannung ändert.

Entsprechend diesem Erfindungsgedanken schlägt der Erfinder eine Schaltungsanordnung zur Erhöhung des Wirkungsgrades eines Leistungsverstärkers, vorzugsweise eines UMTS-Leistungsverstärkers, in einem Telekommunikationsendgerät gemäß dem unabhängigen Vorrichtungsansprüch vor.

Hierdurch wird ein Leistungsverstärker mit sehr hohem Wirkungsgrad zur Verfügung gestellt, bei dem Phasenunterschiede zwischen dem eingespeisten phasenmodulierten Signal und dem am Signalsausgang des Leistungsverstärkers ausgegebenen Signals, die aufgrund des Umschalten des Leistungsverstärkerbetriebs auftraten, kompensiert werden können.

Es ist günstig, wenn die Mittel vor dem Vorverstärker und dem Signaleingang des Leistungsverstärkers angeordnet sind. Hierdurch wird im Vergleich zur Anordnung der Mittel in der HF-Ebene der Implementierungsaufwand geringer gehalten.

Die Mittel zur Kompensation von Phasenunterschieden sollten zumindest ein Speichermedium aufweisen, auf dem Korrekturwerte, vorzugsweise Phasenkorrekturwerte, hinterlegt sind. Es besteht hierdurch die Möglichkeit die Korrekturwerte, die sich zum Beispiel durch Alterung der Bauteile des Leistungsverstärkers verändern, auf dem Speichermedium zu aktualisieren.

Die Korrekturwerte können in Form einer Lock-up-Tabelle auf dem Speichermedium hinterlegt sein. So kann dies besonders einfach durch Faktoren realisiert werden, die dann komplex mit dem eingespeisten Signal multipliziert werden.

Es ist günstig, wenn innerhalb der Lock-up-Tabelle jedem Wert der Ausgangsleistung des Leistungsverstärkers ein Korrekturwert zugeordnet ist. Hierdurch wird es ermöglicht, das auch beim Ändern der Biasspannung in kleinen Stufen beziehungsweise beim kontinuierlichen Ändern der Biasspannung, der Phasensprung des Leistungsverstärkers innerhalb vorgegebener Grenzwerte bleibt.

Auf dem Speichermedium kann zusätzlich die Temperaturabhängigkeit und/oder die Spannungsabhängigkeit der Leistungsverstärkerkennlinie hinterlegt sein. Somit können auch Phasenunterschiede korrigiert werden, die auf diesen Abhängigkeiten der Leistungsverstärkerkennlinie beruhen.

Weiterhin ist es vorteilhaft, wenn der komplexe Multiplizierer aufweisen, der eine Verbindung zum Speichemedium aufweist und die dort hinterlegten Korrekturwerte komplex mit dem Signal des Basisbandes multipliziert. Hierdurch kann das eingespeiste Basisbandsignal sehr einfach in der Phase gedreht werden.

Entsprechend der neuen Schaltungsanordnung schlägt der Erfinder auch ein Verfahren zur Erhöhung des Wirkungsgrades eines Leistungsverstärkers, vorzugsweise eines UMTS-Leistungsverstärkers, in einem Telekommunikationsendgerät gemäß dem unabhängigen Verfahrensansprüch vor.

Hierdurch wird erreicht, dass ein Leistungsverstärker mit sehr hohem Wirkungsgrad betrieben werden kann. Gleichzeitig können durch das neue Verfahren jetzt die Phasenunterschiede zwischen dem eingespeisten phasenmodulierten Signal und dem Signal am Signalsausgang, die aufgrund des Umschalten des Leistungsverstärkerbetriebs auftraten, kompensiert werden.

Für das Verfahren ist es günstig, wenn die Phase der Signale des Basisbandes, die am Signaleingang eingespeist werden, verändert wird. Die Phasenkompensation könnte natürlich auch in der HF-Ebene erfolgen. Vorteil des hier beschriebenen Verfahrens ist jedoch die Flexibilität zum Beispiel hinsichtlich der Phasenkompensation in Abhängigkeit der Frequenz, der Versorgungsspannung des Leistungsverstärkers und der Temperatur.

Es ist vorteilhaft, Korrekturwerte, die vorzugsweise die Phase der Signale ändern können, auf einem Speichermedium zu hinterlegen. Diese Korrekturwerte können beispielsweise in Form einer Lock-up-Tabelle hinterlegt sein. Es besteht hierdurch die Möglichkeit die Korrekturwerte, die sich zum Beispiel durch Alterung der Bauteile verändern, auf dem Speichermedium anzupassen.

Weiterhin ist es günstig, wenn die Temperaturabhängigkeit und/oder die Spannungsabhängigkeit der Leistungsverstärkerkennlinie auf dem Speichermedium hinterlegt wird. Somit können auch Phasenunterschiede der Signale, die durch Änderung der Temperatur und/oder der Spannung auftreten, korrigiert werden.

Die Signale des Basisbandes werden komplex mit den Korrekturwerten multipliziert. Hierdurch kann das eingespeiste Basisbandsignal sehr einfach in der Phase gedreht und somit angepasst werden.

Die Phasenunterschiede, die zwischen den Signalen des Signaleingangs und den Signalen des Signalausgangs auftreten, sollten auf einen vordefinierten Grenzwert eingestellt werden. Dieser Grenzwert sollte bei UMTS-Systemen maximal 60 Grad betragen. Hierdurch können die neuen Forderung der Normierungsgremien eingehalten werden.

Weitere Merkmale der Erfindung ergeben sich aus der nachfolgenden Beschreibung eines bevorzugten Ausführungsbeispiels unter Bezugnahme auf eine Zeichnung:

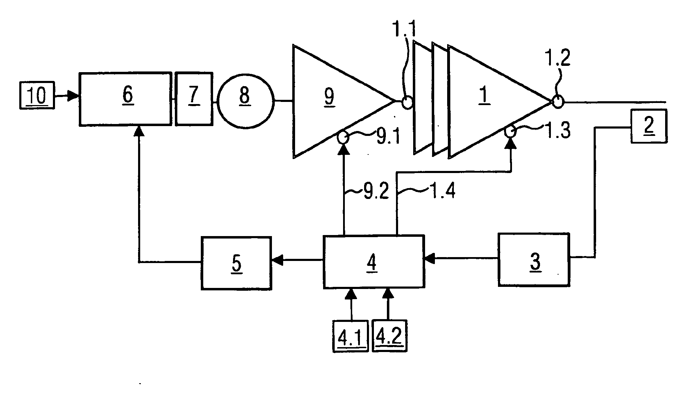

Figur 1: Schaltungsanordnung zur Erhöhung des Wirkungsgrades eines Leistungsverstärkers.

Die Figur 1 zeigt eine Schaltungsanordnung zur Erhöhung des Wirkungsgrades eines Leistungsverstärkers 1. Dieser Leistungsverstärker 1 hat eine lineare Kennlinie und verfügt über einen Signaleingang 1.1 einen Signalausgang 1.2 und einen Biasspannungseingang 1.3.

Durch die Regelung 4 wird in Abhängigkeit der Ausgangsleistung des Leistungsverstärkers 1 die Biasspannung 1.4 am Biasspannungseingang 1.3 des Leistungsverstärkers 1 und die Verstärkung des Vorverstärkers 9 über die Gainspannung 9.2 am Gainspannungseingang 9.1 des Vorverstärkers 9 eingestellt. Beim Umschalten der Biasspannung 1.4 muss die Eingangsleistung des Leistungsverstärkers 1 mit Hilfe des Vorverstärkers 9 nachgeregelt werden, da die Verstärkung des Leistungsverstärkers 1 ebenfalls von der Biasspannung 1.4 abhängt.

In einer Lock-up-Tabelle 5 sind nun Korrekturwerte für jeden Umschaltpunkt der Ausgangsleistung abgespeichert. Werden nun von der Regelung 4 die Gainspannung 9.2 und die Biasspannung 1.4 geändert, so wird zusätzlich der entsprechende Korrekturwert für die zu erwartende Phasendrehung aus der Lock-up-Tabelle 5 ausgelesen und mit einem komplexen Multiplizierer 6 komplex mit dem Basisbandsignal 10 multipliziert. Dadurch wird das Basisbandsignal 10 in seiner Phase so gedreht, dass der Sprung in der Trägerphase kompensiert werden kann. Je nach geforderter Genauigkeit können die Korrekturwerte in der Lock-up-Tabelle 5 entweder in der Fertigung abgeglichen werden oder statisch hinterlegt sein. Zusätzlich können bei Bedarf die Korrekturwerte die Abhängigkeit des Phasensprungs von der Temperatur 4.1 und der Versorgungsspannung Vbatt 4.2 berücksichtigen.

Insgesamt wird also durch die Erfindung eine Schaltungsanordnung und ein Verfahren zur Verfügung gestellt, die/das es ermöglicht den Wirkungsgrad eines Leistungsverstärkers zu erhöhen und gleichzeitig Phasenunterschiede zwischen den eingespeisten und ausgegeben Signalen des Leistungsverstärkers zu kompensieren, die beim Umschalten der Betriebsweise des Leistungsverstärkers auftreten.

Es versteht sich, dass die vorstehend genannten Merkmale der Erfindung nicht nur in der jeweils angegebenen Kombination, sondern auch in anderen Kombinationen oder in Alleinstellung verwendbar sind, ohne den Rahmen der Erfindung zu verlassen.

Liste der verwendeten Abkürzungen:

| AM | Amplitudenmodulation |
| DAC | Digital-Analog-Converter (D/A-Wandler) |
| DC | Direct Current |
| FDD | Frequency divison duplex |
| FET | Feld Effekt Transistor |
| GPP | Generation Partnership Project |
| LUT | Look-up-Tabelle |
| PA | Power Amplifier (Verstärker) |
| PM | Phasenmodulation |
| UMTS | Universal mobile telecommunications system |
| VGA | Variable Gain Amplifier |

Bezugszeichenliste

| 1 | Leistungsverstärker PA |

| 1.1 | Signaleingang des Leistungsverstärkers |
| 1.2 | Signalausgang des Leistungsverstärkers |
| 1.3 | Biasspannungseingang des Leistungsverstärkers |
| 1.4 | Biasspannung Vbias |
| 2 | Koppler |
| 3 | Detektor |
| 4 | Regelung/Steuerung |
| 4.1 | Temperatur |
| 4.2 | Versorgungsspannung Vbatt |
| 5 | LUT = Look-up-Tabelle |
| 6 | Komplexer Multiplizierer |
| 7 | DAC Digital-Analog-Converter = D/A-Wandler |
| 8 | Modulator |
| 9 | Vorverstärker VGA = Variable Gain Amplifier |
| 9.1 | Gainspannungseingang des VGA |
| 9.2 | Gainspannung Vgain |
| 10 | Basisbandsignal |

**Patentansprüche**

1. Schaltungsanordnung zur Erhöhung des Wirkungsgrades eines Leistungsverstärkers (1), vorzugsweise eines UMTS-Leistungsverstärkers, in einem Telekommunikationsendgerät, mindestens bestehend aus:

einem Leistungsverstärker (1) mit linearer Kennlinie, der einen Signaleingang (1.1), einen Signalausgang(1.2) und einen Biasspannungseingang (1.3) aufweist, wobei am Signaleingang (1.1) ein mittels Modulation eines Basisbandsignals (10) erzeugtes phasenmoduliertes und/oder amplitudenmoduliertes Signal eingespeist wird, das am Signalausgang (1.2) als verstärktes Signal ausgegeben wird und über eine Spannung (1.4) am Biasspannungseingang (1.3) die Betriebsweise des Leistungsverstärkers (1) umgeschaltet werden kann, wobei Mittel (5, 6) angeordnet sind, die Phasenunterschiede kompensieren, die durch Änderung der Betriebsweise des Leistungsverstärkers (1) zwischen dem Signal des Signaleingangs (1.1) und dem Signal des Signalausgangs (1.2) auftreten, und die Mittel (5, 6) einen komplexen Multiplizierer (6) aufweisen, der das Basisbandsignal (10) komplex mit Korrekturwerten multipliziert, **gekennzeichnet durch** einen Vorverstärker (9), mit dem die Eingangsleistung des Leistungsverstärkers (1) variiert werden kann, und eine Regelung (4), die in Abhängigkeit der Ausgangsleistung des Leistungsverstärkers (1) die Spannung (1.4) am Biasspannungseingang (1.3) und/oder die Verstärkung des Vorverstärkers (9) einstellt.

**2.** Schaltungsanordnung gemäß Patentanspruch 1, **dadurch gekennzeichnet, dass** die Mittel (5 und 6) vor dem Vorverstärker (9) und dem Signaleingang (1.1) des Leistungsverstärkers (1) angeordnet sind.

**3.** Schaltungsanordnung gemäß einem der Patentansprüche 1 und 2, **dadurch gekennzeichnet, dass** die Mittel (5, 6) zumindest ein Speichermedium aufweisen, auf dem die Korrekturwerte, vorzugsweise Phasenkorrekturwerte, hinterlegt sind

**4.** Schaltungsanordnung gemäß Patentanspruch 3, **dadurch gekennzeichnet, dass** die Korrekturwerte in Form einer Look-up-Tabelle (5) hinterlegt sind.

**5.** Schaltungsanordnung gemäß Patentanspruch 4, **dadurch gekennzeichnet, dass** die Korrekturwerte für jeden Umschaltpunkt der Ausgangsleistung abgespeichert sind.

**6.** Schaltungsanordnung gemäß einem der Patentansprüche 4 und 5, **dadurch gekennzeichnet, dass** die Look-up-Tabelle (5) für jeden Wert der Ausgangsleistung des Leistungsverstärkers (1) einen Korrekturwert aufweist.

**7.** Schaltungsanordnung gemäß einem der Patentansprüche 1 bis 4, **dadurch gekennzeichnet, dass** auf dem Speichermedium die Temperaturabhängigkeit und/oder die Spannungsabhängigkeit der Leistungsverstärkerkennlinie gespeichert sind.

**8.** Schaltungsanordnung gemäß einem der Patentansprüche 3 bis 7, **dadurch gekennzeichnet, dass** der komplexe Multiplizierer (6) eine Verbindung zum Speichermedium aufweist und die dort hinterlegten Korrekturwerte komplex mit dem Basisbandsignal (10) multipliziert.

**9.** Verfahren zur Erhöhung des Wirkungsgrades eines Leistungsverstärkers (1), vorzugsweise eines UMTS-Leistungsverstärkers, in einem Telekommunikationsendgerät, bei dem
ein mittels Modulation eines Basisbandsignals (10) erzeugtes phasenmoduliertes und/oder amplitudenmoduliertes Signal in einen Signaleingang (1.1) eines Leistungsverstärkers (1) mit überwiegend linearer Kennlinie eingespeist und am Signalausgang (1.2) als verstärktes Signal ausgegeben wird,
die Betriebsweise des Leistungsverstärkers (1) durch Veränderung einer Spannung (1.4) an einem Biasspannungseingang (1.3) des Leistungsverstärkers (1) umgeschaltet wird,
die Eingangsleistung des Leistungsverstärkers (1) mittels eines Vorverstärkers (9) variiert wird, und
die Spannung (1.4) am Biasspannungseingang (1.3) und/oder die Verstärkung des Vorverstärkers (9) in Abhängigkeit der Ausgangsleistung des Leistungsverstärkers (1) geregelt wird, wobei Phasenunterschiede, die durch das Umschalten der Betriebsweise des Leistungsverstärkers (1) zwischen dem Signal des Signaleingangs (1.1) und dem Signal des Signalausgangs (1.2) auftreten, durch Veränderung der Phase zumindest eines Signals kompensiert werden, indem das Basisbandsignal (10) komplex mit Korrekturwerten multipliziert wird.

**10.** Verfahren gemäß Patentanspruch 9, **dadurch gekennzeichnet, dass** die Korrekturwerte auf einem Speichermedium hinterlegt werden, vorzugsweise in Form einer Look-up-Tabelle (5).

**11.** Verfahren gemäß Patentanspruch 10, **dadurch gekennzeichnet, dass** die Korrekturwerte für jeden Umschaltpunkt der Ausgangsleistung abgespeichert werden.

**12.** Verfahren gemäß einem der Patentansprüche 9 bis 11, **dadurch gekennzeichnet, dass** die Temperaturabhängigkeit und/oder die Spannungsabhängigkeit der Leistungsverstärkerkennlinie auf dem Speichermedium hinterlegt wird, und die Phasenunterschiede der Signale, die durch Änderung der Temperatur und/oder der Spannung auftreten, korrigiert werden.

**13.** Verfahren gemäß einem der Patentansprüche 9 bis 12, **dadurch gekennzeichnet, dass** die Phasenunterschiede, die zwischen dem Signal des Signaleingangs (1.1) und dem Signal des Signalausgangs (1.2) auftreten, auf einen vordefinierten Grenzwert begrenzt werden, vorzugsweise auf maximal 60 Grad bei UMTS-Systemen.

**Claims**

**1.** A circuit for enhancing the efficiency of a power amplifier (1), preferably of a UMTS power amplifier, in a telecommunications terminal, at least comprising:

a power amplifier (1) with a linear characteristic curve having a signal input (1.1), a signal output (1.2) and a bias voltage input (1.3), wherein a phase modulated and/or amplitude modulated signal generated by means of the signal input (1.1) is fed at the amplified signal which is outputted at the signal output (1.2) as an amplified signal and the operational mode of the power amplifier (1) can be switched via a voltage (1.4) at the bias voltage input (1.3), wherein
means (5, 6) are arranged to compensate for the phase differences, which arise from changing the operational mode of the power amplifier (1) between the signal of the signal input (1.1) and the signal of the signal output (1.2) and the means (5, 6) have a complex multiplier (6) that complexly multiplies the base band signal (10) by correction values, **characterized by** a preamplifier (9) by means of which the input power of the power amplifier (1) can be varied, and a regulation (4) which adjusts the voltage (1.4) at the bias voltage input (1.3) and/or the amplification of the preamplifier (9) depending on the output power of the power amplifier (1).

2. The circuit of claim 1, **characterized in that** the means (5 and 6) are arranged ahead of the preamplifier (9) and the signal input (1.1) of the power amplifier (1).

3. The circuit of claim 1 and 2, **characterized by** the means (5, 6) having at least one storage medium, on which the correction values, preferably phase correction values, are deposited.

4. The circuit of claim 3, **characterized in that** the correction values are deposited in the form of a look-up-table (5).

5. The circuit of claim 4, **characterized in that** the correction values are stored for each switch point of the output power.

6. The circuit of claims 4 and 5, **characterized in that** the look-up table (5) has a correction value for each value of the output power of the power amplifier (1).

7. The circuit of any one of claims 1 to 4, **characterized in that** the temperature dependency and/or the voltage dependency of the power amplifier characteristic curve are stored on the storage medium.

8. The circuit of any one of claims 3 to 7, **characterized in that** the complex multiplier (6) has a connection to the storage medium and complexly multiplies the correction values deposited there by the base band signal (10).

9. A method for enhancing the efficiency of a power amplifier (1), preferably of a UMTS power amplifier, in a telecommunications terminal, in which a phase modulated and/or amplitude modulated signal generated by means of modulation of a base band signal (10) is fed into a signal input (1.1) of a power amplifier (1) with a substantially linear characteristic curve and is outputted at the signal output (1.2) as an amplified signal, the operational mode of the power amplifier (1) is switched by changing a voltage (1.4) at a bias voltage input (1.3) of the power amplifier, the input power of the power amplifier (1) is varied by means of a preamplifier (9), and the voltage (1.4) at the bias voltage input (1.3) and/or the amplification of the preamplifier (9) is regulated depending on the output power of the power amplifier (1), in which phase differences arising from the switching of the operational mode of the power amplifier (1) between the signal of the signal input (1.1) and the signal of the signal output (1.2) are compensated by changing the phase of at least one signal by complexly multiplying the base band signal (10) by correction values.

10. The method of claim 9, **characterized in that** the correction values are deposited on a storage medium, preferably in the form of a look-up table.

11. The method of claim 10, **characterized in that** the correction values are stored for each switch point of the output power.

12. The method of any one of the claims 9 to 11, **characterized in that** the temperature dependency and/or the voltage dependency of the power amplifier characteristic curve is deposited on the storage medium, and the phase differences of the signals, arising from the changing of the temperature and/or the voltage, are corrected.

13. The method of any one of the claims 9 to 12, **characterized in that** the phase differences arising between the signal of the signal input (1.1) and the signal of the signal output (1.2) are limited to a predefined boundary value, preferably to a maximum of 60 degrees in UMTS systems.

**Revendications**

1. Circuit pour l'augmentation de l'efficacité d'un amplificateur de puissance (1), de préférence d'un amplificateur de puissance UMTS, dans un terminal de télécommunication, au moins comprenant:

   un amplificateur de puissance (1) avec une caractéristique linéaire, comportant une entrée de signal (1.1), une sortie de signal (1.2) et une entrée de tension de bias (1.3), un signal généré par modulation d'un signal de bande de base (10), modulé en phase et/ou modulé en amplitude, étant entré à l'entrée de signal (1.1), qui est sorti à la sortie de signal (1.2) comme signal amplifié et le mode d'opération de l'amplificateur peut être commuté via une tension (1.4) à la sortie de tension de bias, des moyens (5, 6) étant agencés pour compenser les différences de phase apparaissant par changement du mode d'opération de l'amplificateur de puissance (1) entre le signal de l'entrée de signal (1.1) et le signal de la sortie de signal (1.2), et les moyens (5, 6) comportant un multiplicateur complexe (6), qui multiplie le signal de la bande de base (10) complexement avec des valeurs correctrices,
**caractérisé par**
un préamplificateur (9), par lequel la puissance d'entrée de l'amplificateur de puissance (1) peut être variée, et
une réglementation (4), qui en fonction de la puissance de sortie de l'amplificateur de puissance (1) ajuste la tension (1.4) à l'entrée de la tension de bias (1.3) et/ou l'amplification du préamplificateur (9).

2. Circuit selon la revendication 1, **caractérisé en ce que** les moyens (5 et 6) sont agencés devant le préamplificateur (9) et l'entrée de signal (1.1) de l'amplificateur de puissance (1).

3. Circuit selon l'une des revendications 1 et 2, **caractérisé en ce que** les moyens (5, 6) comportent au moins un support d'enregistrement, sur lequel les valeurs correctrices, de préférence des valeurs correctrices de phase, sont déposées.

4. Circuit selon la revendication 3, **caractérisé en ce que** les valeurs correctrices sont déposées sous forme d'une table de look-up (5).

5. Circuit selon la revendication 4, **caractérisé en ce que** les valeurs correctrices sont enregistrées pour chaque point de commutation de la puissance de sortie.

6. Circuit selon l'une des revendications 4 et 5, **caractérisé en ce que** la table de look-up (5) comporte une value correctrice pour chaque valeur de la puissance de sortie de l'amplificateur de puissance (1).

7. Circuit selon l'une des revendications 1 à 4, **caractérisé en ce que** la dépendance de température et/ou la dépendance de tension de la caractéristique de l'amplificateur de puissance sont enregistrées sur le support d'enregistrement.

8. Circuit selon l'une des revendications 3 à 7, **caractérisé en ce que** le multiplicateur complexe (6) comporte une connexion avec le support d'enregistrement et multiplie les valeurs correctrices y déposées complexement avec le signal de bande de base (10).

9. Procédé pour l'augmentation de l'efficacité d'un amplificateur de puissance (1), de préférence d'un amplificateur de puissance UMTS, dans un terminal de télécommunication, dans lequel
un signal généré par modulation d'un signal de bande de base (10), modulé en phase et/ou modulé en amplitude, est entré dans une entrée de signal (1.1) d'un amplificateur de puissance (1) avec une caractéristique sensiblement linéaire et est sorti à la sortie de signal (1.2) comme signal amplifié,
le mode d'opération de l'amplificateur de puissance (1) est commuté par changement d'une tension (1.4) à une entrée de tension de bias (1.3) de l'amplificateur de puissance (1),
la puissance d'entrée de l'amplificateur de puissance (1) est variée par un préamplificateur (9), et
la tension (1.4) à l'entrée de tension de bias (1.3) et/ou l'amplification du préamplificateur (9) est réglée en fonction de la puissance de sortie de l'amplificateur de puissance (1),
des différences de phase apparaissant par la commutation du mode d'opération de l'amplificateur de puissance (1) entre le signal de l'entrée de signal (1.1) et le signal de la sortie de signal (1.2) étant compensées par changement de la phase d'au moins un signal en multipliant le signal de bande de base (10) complexement avec des valeurs correctrices.

10. Procédé selon la revendication 9, **caractérisé en ce que** les valeurs correctrices sont déposées sur le support d'enregistrement, de préférence sous forme d'une table de look-up (5).

11. Procédé selon la revendication 10, **caractérisé en ce que** les valeurs correctrices sont enregistrées pour chaque point de commutation de la puissance de sortie.

12. Procédé selon l'une des revendications 9 à 11 **caractérisé en ce que** la dépendance de température et/ou la dépendance de tension de la caractéristique de l'amplificateur de puissance est déposée et les différences de phase des signaux apparaissant par changement de la température et/ou de la tension sont corrigées.

13. Procédé selon l'une des revendications 9 à 12 **caractérisé en ce que** les différences de phase apparaissant entre le signal de l'entrée de signal (1.1) et le signal de la sortie de signal (1.2) sont limitées à une valeur limite prédéfinie, de préférence à un maximum de 60 degrés dans les systèmes UMTS.

**IN DER BESCHREIBUNG AUFGEFÜHRTE DOKUMENTE**

**In der Beschreibung aufgeführte Patentdokumente**

- US 20030030490 A1
- US 20020146993 A1
- US 5101173 A